# EUROPÄISCHE PATENTANMELDUNG

(11) **EP 3 316 463 A1**
(43) Veröffentlichungstag der Anmeldung: **02.05.2018**
(21) Anmeldenummer: 16196035.6
(22) Anmeldetag: 27.10.2016
(51) Int. Cl.: H02M 1/38, H03K 17/06

(54) **ÄNDERN EINES SCHALTZUSTANDS EINER SCHALT-HALBBRÜCKE**

(71) Anmelder: Siemens Aktiengesellschaft, 80333 München (DE)
(72) Erfinder: März, Andreas, 91227 Leinburg (DE); Bakran, Mark-Matthias, 91052 Erlangen (DE)

(57) **Zusammenfassung**

Die Erfindung betrifft ein Verfahren zum Ändern eines Schaltzustands einer Schalt-Halbbrücke (1), die zwei Feldeffekttransistoren (5, 7) aufweist, von einem ersten Schaltzustand, in dem eine Gate-Source-Spannung (U_{GS1}) eines ersten Feldeffekttransistors (5) ein Einschaltniveau (Uₒₙ) annimmt und eine Gate-Source-Spannung (U_{GS2}) des zweiten Feldeffekttransistors (7) ein erstes Abschaltniveau (U_{off1}) annimmt, zu einem zweiten Schaltzustand, in dem die Gate-Source-Spannung (U_{GS1}) des ersten Feldeffekttransistors (5) das erste Abschaltniveau (U_{off1}) annimmt und die Gate-Source-Spannung (U_{GS2}) des zweiten Feldeffekttransistors (7) das Einschaltniveau (Uₒₙ) annimmt. Dabei wird zunächst die Gate-Source-Spannung (U_{GS1}) des ersten Feldeffekttransistors (5) von dem Einschaltniveau (Uₒₙ) auf ein zweites Abschaltniveau (U_{off2}), dessen Betrag größer als der Betrag des ersten Abschaltniveaus (U_{off1}) ist, geändert. Dann wird die Gate-Source-Spannung (U_{GS2}) des zweiten Feldeffekttransistors (7) von dem ersten Abschaltniveau (U_{off1}) auf das Einschaltniveau (Uₒₙ) geändert. Danach wird die Gate-Source-Spannung (U_{GS1}) des ersten Feldeffekttransistors (5) von dem zweiten Abschaltniveau (U_{off2}) auf das erste Abschaltniveau (U_{off1}) geändert.

## Beschreibung

Die Erfindung betrifft ein Verfahren und eine Schaltanordnung zum Ändern eines Schaltzustands einer Schalt-Halbbrücke, die zwei Feldeffekttransistoren aufweist, von einem ersten Schaltzustand, in dem ein erster Feldeffekttransistor eingeschaltet ist und der zweite Feldeffekttransistor abgeschaltet ist, zu einem zweiten Schaltzustand, in dem der erste Feldeffekttransistor abgeschaltet ist und der zweite Feldeffekttransistor eingeschaltet ist.

Insbesondere betrifft die Erfindung ein Verfahren und eine Schaltanordnung zum Ändern eines Schaltzustands einer Schalt-Halbbrücke, die zwei so genannte WBG-Feldeffekttransistoren aufweist (WBG = Wide-Bandgap). Unter einem WBG-Feldeffekttransistor wird ein Feldeffekttransistor verstanden, dessen Grundmaterial ein Halbleiter mit breitem Bandabstand (= Energieabstand zwischen Valenzband und Leitungsband) wie Siliziumkarbid oder Galliumnitrid ist. WBG-Feldeffekttransistoren eignen sich aufgrund ihrer geringeren Schaltverluste im Vergleich zu den häufig eingesetzten Bipolartransistoren mit isolierter Gate-Elektrode (IGBT) insbesondere vorteilhaft zur Verbesserung der Leistungsdichte von Stromrichtern wie Pulswechselrichtern oder Gleichspannungswandlern. Damit kann bei gleichen Schaltverlusten die Schaltfrequenz merklich erhöht werden, wodurch die Baugröße von passiven Komponenten im System wie von Filtern, Transformatoren und Zwischenkreiskondensatoren reduziert werden kann.

Bei hohen Schaltgeschwindigkeiten kann bei dem Abschalten eines Feldeffekttransistors einer Schalt-Halbbrücke der Effekt des parasitären Wiederaufsteuerns des Feldeffekttransistors auftreten. Dieser Effekt wird auch als parasitäres Wiedereinschalten oder "Selfturn-On" bezeichnet. Dabei wird die Gate-Source-Spannung zwischen Gate und Source des abschaltenden Feldeffekttransistors aufgrund eines kapazitiven Verschiebestroms kurzzeitig über die Schwellenspannung (Threshhold Voltage) des Feldeffekttransistors angehoben, wodurch der Feldeffekttransistor wieder leitend wird. Dies schlägt sich in stark erhöhten Abschaltverlusten des abschaltenden Feldeffekttransistors und Einschaltverlusten des einschaltenden komplementären Feldeffekttransistors der Schalt-Halbbrücke nieder.

Der Erfindung liegt die Aufgabe zugrunde, ein Verfahren und eine Schaltanordnung zum Ändern eines Schaltzustands einer Schalt-Halbbrücke, die zwei Feldeffekttransistoren aufweist, anzugeben, die insbesondere hinsichtlich des Vermeidens eines parasitäres Wiedereinschaltens beim Abschalten eines Feldeffekttransistors der Schalt-Halbbrücke verbessert sind.

Die Aufgabe wird erfindungsgemäß hinsichtlich des Verfahrens durch die Merkmale des Anspruchs 1 und hinsichtlich der Schaltanordnung durch die Merkmale des Anspruchs 10 gelöst.

Vorteilhafte Ausgestaltungen der Erfindung sind Gegenstand der Unteransprüche.

Bei dem erfindungsgemäßen Verfahren wird ein Schaltzustand einer Schalt-Halbbrücke, die zwei Feldeffekttransistoren aufweist, von einem ersten Schaltzustand, in dem eine Gate-Source-Spannung eines ersten Feldeffekttransistors ein Einschaltniveau annimmt und eine Gate-Source-Spannung des zweiten Feldeffekttransistors ein erstes Abschaltniveau annimmt, zu einem zweiten Schaltzustand, in dem die Gate-Source-Spannung des ersten Feldeffekttransistors das erste Abschaltniveau annimmt und die Gate-Source-Spannung des zweiten Feldeffekttransistors das Einschaltniveau annimmt, geändert. Dabei wird zunächst die Gate-Source-Spannung des ersten Feldeffekttransistors von dem Einschaltniveau auf ein zweites Abschaltniveau, dessen Betrag größer als der Betrag des ersten Abschaltniveaus ist, geändert. Dann wird die Gate-Source-Spannung des zweiten Feldeffekttransistors von dem ersten Abschaltniveau auf das Einschaltniveau geändert. Danach wird die Gate-Source-Spannung des ersten Feldeffekttransistors von dem zweiten Abschaltniveau auf das erste Abschaltniveau geändert.

Das erfindungsgemäße Verfahren sieht also vor, bei einem Wechsel des Schaltzustands der Schalt-Halbbrücke die Gate-Source-Spannung des abschaltenden (ersten) Feldeffekttransistors vorübergehend auf ein betragsmäßig erhöhtes (zweites) Abschaltniveau zu ändern und den anderen (zweiten) Feldeffekttransistor einzuschalten, während die Gate-Source-Spannung des abschaltenden Feldeffekttransistors dieses betragsmäßig erhöhte Abschaltniveau annimmt. Durch diese vorübergehende Änderung des Abschaltniveaus der Gate-Source-Spannung des ersten Feldeffekttransistors wird der Abstand des Abschaltniveaus von der Schwellenspannung des ersten Feldeffekttransistors kurzzeitig für die Zeitdauer des Kommutierungsvorgangs erhöht, wodurch ein parasitäres Wiedereinschalten des ersten Feldeffekttransistors vermieden wird. Dadurch wird vorteilhaft bei schnellem Schalten der Feldeffekttransistoren eine Erhöhung der Schaltverluste durch ein parasitäres Wiedereinschalten des jeweils abschaltenden Feldeffekttransistors vermieden.

Ein erstes Ausführungsbeispiel des Verfahrens sieht vor, dass die Gate-Source-Spannung des ersten Feldeffekttransistors von dem Einschaltniveau auf das zweite Abschaltniveau geändert wird, indem eine Steuerspannung des ersten Feldeffekttransistors von dem Einschaltniveau auf das zweite Abschaltniveau geändert wird. Dieses Ausführungsbeispiel sieht also vor, die vorübergehende Änderung des Abschaltniveaus des ersten Feldeffekttransistors durch eine entsprechende Änderung der Steuerspannung des ersten Feldeffekttransistors zu bewirken.

Eine Ausgestaltung des ersten Ausführungsbeispiels des Verfahrens sieht vor, dass eine erste Zeitdauer vorgegeben wird, und dass die Gate-Source-Spannung des zweiten Feldeffekttransistors von dem ersten Abschaltniveau auf das Einschaltniveau zu einem Zeitpunkt geändert wird, der in einem durch die erste Zeitdauer definierten zeitlichen Abstand auf das Ändern der Steuerspannung des ersten Feldeffekttransistors von dem Einschaltniveau auf das zweite Abschaltniveau folgt. Die Vorgabe der ersten Zeitdauer für das Ändern der Gate-Source-Spannung des zweiten Feldeffekttransistors nach dem Ändern der Steuerspannung des ersten Feldeffekttransistors ermöglicht die Definition eines geeigneten Zeitpunkts für das Einschalten des zweiten Feldeffekttransistors nach dem Abschalten des ersten Feldeffekttransistors.

Eine weitere Ausgestaltung des ersten Ausführungsbeispiels des Verfahrens sieht vor, dass die Gate-Source-Spannung des ersten Feldeffekttransistors von dem zweiten Abschaltniveau auf das erste Abschaltniveau geändert wird, indem die Steuerspannung des ersten Feldeffekttransistors von dem zweiten Abschaltniveau auf das erste Abschaltniveau geändert wird. Dadurch wird die Gate-Source-Spannung des ersten Feldeffekttransistors durch die Steuerspannung nach dem Abschalten des ersten Feldeffekttransistors wieder auf das normale (erste) Abschaltniveau geändert.

Eine weitere Ausgestaltung des ersten Ausführungsbeispiels des Verfahrens sieht vor, dass eine zweite Zeitdauer vorgegeben wird, und dass die Gate-Source-Spannung des ersten Feldeffekttransistors von dem zweiten Abschaltniveau auf das erste Abschaltniveau zu einem Zeitpunkt geändert wird, der in einem durch die zweite Zeitdauer definierten zeitlichen Abstand auf das Ändern der Gate-Source-Spannung des zweiten Feldeffekttransistors von dem ersten Abschaltniveau auf das Einschaltniveau folgt. Die Vorgabe der zweiten Zeitdauer für das Ändern der Gate-Source-Spannung des ersten Feldeffekttransistors ermöglicht die Definition eines geeigneten Zeitpunkts für das Absenken des Betrags des Abschaltniveaus von dem erhöhten Wert auf den normalen Wert.

Ein zweites Ausführungsbeispiel des Verfahrens sieht vor, dass dem Gate-Anschluss des ersten Feldeffekttransistors eine Zusatzschaltung mit einer Induktivität vorgeschaltet wird, die bei einer Änderung einer Steuerspannung des ersten Feldeffekttransistors von dem Einschaltniveau auf das erste Abschaltniveau eine vorübergehende Änderung der Gate-Source-Spannung des ersten Feldeffekttransistors auf das zweite Abschaltniveau bewirkt, und dass zur Änderung der Gate-Source-Spannung des ersten Feldeffekttransistors von dem Einschaltniveau auf das zweite Abschaltniveau die Steuerspannung des ersten Feldeffekttransistors von dem Einschaltniveau auf das erste Abschaltniveau geändert wird. Dieses Ausführungsbeispiel sieht also vor, die vorübergehende Erhöhung des Betrags des Abschaltniveaus des ersten Feldeffekttransistors durch eine zusätzliche Induktivität zu bewirken, die dem Gate-Anschluss des ersten Feldeffekttransistors vorgeschaltet wird. Diese Induktivität wirkt mit der Eingangskapazität des ersten Feldeffekttransistors, die die Summe der Kapazitäten zwischen Gate und Source und zwischen Gate und Drain des ersten Feldeffekttransistors ist, sowie einer parasitären Induktivität weiterer Komponenten der Schaltordnung als ein Reihenschwingkreis, der von einer Änderung der Steuerspannung des ersten Feldeffekttransistors angeregt wird und ein Überschwingen der Gate-Source-Spannung des ersten Feldeffekttransistors auf das zweite Abschaltniveau bewirkt. Dadurch braucht im Unterschied zu dem ersten Ausführungsbeispiel nicht die Steuerspannung des ersten Feldeffekttransistors vorübergehend auf das zweite Abschaltniveau geändert werden, um das Abschaltniveau des ersten Feldeffekttransistors zu ändern.

Eine Ausgestaltung des zweiten Ausführungsbeispiels des Verfahrens sieht vor, dass eine Zeitdauer vorgegeben wird, und dass die Gate-Source-Spannung des zweiten Feldeffekttransistors von dem ersten Abschaltniveau auf das Einschaltniveau zu einem Zeitpunkt geändert wird, der in einem durch die Zeitdauer definierten zeitlichen Abstand auf das Ändern der Steuerspannung des ersten Feldeffekttransistors von dem Einschaltniveau auf das erste Abschaltniveau folgt. Die Zeitdauer wird dabei derart vorgegeben, dass der zweite Feldeffekttransistor durch die Änderung seiner Gate-Source-Spannung dann eingeschaltet wird, wenn die Gate-Source-Spannung des ersten Feldeffekttransistors das zweite Abschaltniveau annimmt.

Eine erfindungsgemäße Schaltanordnung zum Ändern eines Schaltzustands einer Schalt-Halbbrücke, die zwei Feldeffekttransistoren aufweist, von einem ersten Schaltzustand, in dem eine Gate-Source-Spannung eines ersten Feldeffekttransistors ein Einschaltniveau annimmt und eine Gate-Source-Spannung des zweiten Feldeffekttransistors ein erstes Abschaltniveau annimmt, zu einem Schaltzustand, in dem die Gate-Source-Spannung des ersten Feldeffekttransistors das erste Abschaltniveau annimmt und die Gate-Source-Spannung des zweiten Feldeffekttransistors das Einschaltniveau annimmt, weist für jeden Feldeffekttransistor einen Gate-Treiber zum Ansteuern des Feldeffekttransistors mit einer Steuerspannung und eine zwischen den Gate-Treiber und einen Gate-Anschluss des Feldeffekttransistors schaltbare Zusatzschaltung auf. Dabei ist durch den Gate-Treiber und die Zusatzschaltung eine Gate-Source-Spannung des Feldeffekttransistors auf das Einschaltniveau, das erste Abschaltniveau und ein zweites Abschaltniveau, dessen Betrag größer als der Betrag des ersten Abschaltniveaus ist, einstellbar. Die erfindungsgemäße Schaltanordnung ermöglicht die Realisierung des erfindungsgemäßen Verfahrens mit den oben bereits genannten Vorteilen.

Ein erstes Ausführungsbeispiel der Schaltanordnung sieht vor, dass jede Zusatzschaltung einen Zusatz-Gate-Treiber zur Einstellung der Steuerspannung auf das erste Abschaltniveau aufweist, und mit dem Gate-Treiber die Steuerspannung auf das Einschaltniveau und das zweite Abschaltniveau einstellbar ist. Dieses Ausführungsbeispiel der Schaltanordnung ermöglicht die Realisierung des oben beschriebenen ersten Ausführungsbeispiels des erfindungsgemäßen Verfahrens.

Ein zweites Ausführungsbeispiel der Schaltanordnung sieht vor, dass jede Zusatzschaltung eine Induktivität aufweist, die bei einer Änderung der Steuerspannung von dem Einschaltniveau auf das erste Abschaltniveau eine vorübergehende Änderung der Gate-Source-Spannung des jeweiligen Feldeffekttransistors auf das zweite Abschaltniveau bewirkt. Dieses Ausführungsbeispiel der Schaltanordnung ermöglicht die Realisierung des oben beschriebenen zweiten Ausführungsbeispiels des erfindungsgemäßen Verfahrens.

Bei allen Ausführungsbeispielen des erfindungsgemäßen Verfahrens und der erfindungsgemäßen Schaltanordnung kann jeder Feldeffekttransistor ein WBG-Feldeffekttransistor sein, d.h. jeder Feldeffekttransistor kann als Grundmaterial einen Halbleiter mit breitem Bandabstand, insbesondere Siliziumkarbid, aufweisen. Die Erfindung eignet sich besonders vorteilhaft für Schalt-Halbbrücken mit WBG-Feldeffekttransistoren, da diese hohe Schaltgeschwindigkeiten ermöglichen, bei denen ein parasitäres Wiedereinschalten des jeweils abschaltenden Feldeffekttransistors auftreten kann.

Ein erfindungsgemäßer Stromrichter weist wenigstens eine Schalt-Halbbrücke, die zwei Feldeffekttransistoren aufweist, und eine erfindungsgemäße Schaltanordnung zum Ändern eines Schaltzustands der Schalt-Halbbrücke auf. Die Vorteile eines derartigen Stromrichters ergeben sich aus den oben bereits genannten Vorteilen des erfindungsgemäßen Verfahrens bzw. der erfindungsgemäßen Schaltanordnung.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: einen Schaltplan eines Stromrichters mit einer Schalt-Halbbrücke und einer Schaltanordnung zum Ändern eines Schaltzustands der Schalt-Halbbrücke,
- FIG 2: einen Teil-Schaltplan einer Schalt-Halbbrücke und eines ersten Ausführungsbeispiels einer Schaltanordnung zum Ändern eines Schaltzustands der Schalt-Halbbrücke,
- FIG 3: zeitliche Verläufe von mit der in FIG 2 dargestellten Schaltanordnung erzeugten Steuerspannungen und GateSource-Spannungen der Feldeffekttransistoren einer Schalt-Halbbrücke,
- FIG 4: einen Teil-Schaltplan einer Schalt-Halbbrücke und eines zweiten Ausführungsbeispiels einer Schaltanordnung zum Ändern eines Schaltzustands der Schalt-Halbbrücke, und
- FIG 5: zeitliche Verläufe von mit der in FIG 4 dargestellten Schaltanordnung erzeugten Steuerspannungen und Gate-Source-Spannungen der Feldeffekttransistoren einer Schalt-Halbbrücke.

Einander entsprechende Teile sind in allen Figuren mit denselben Bezugszeichen versehen.

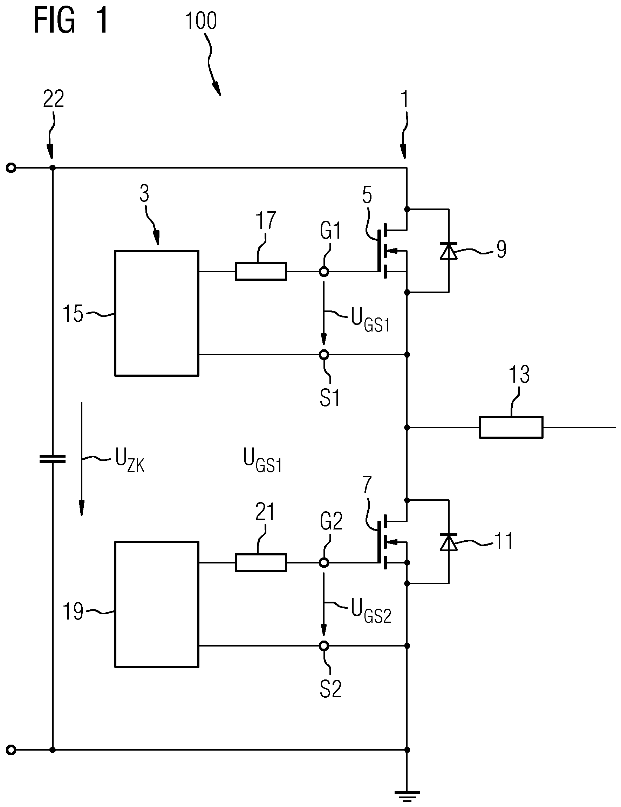

FIG 1 zeigt einen Schaltplan eines Stromrichters 100 mit einer Schalt-Halbbrücke 1 und einer Schaltanordnung 3 zum Ändern eines Schaltzustands der Schalt-Halbbrücke 1. Der Stromrichter 100 ist als ein einphasiger Pulswechselrichter ausgebildet.

Die Schalt-Halbbrücke 1 weist einen ersten Feldeffekttransistor 5 und einen zweiten Feldeffekttransistor 7, sowie optional eine zu dem ersten Feldeffekttransistor 5 antiparallel geschaltete erste Freilaufdiode 9 und eine zu dem zweiten Feldeffekttransistor 7 antiparallel geschaltete zweite Freilaufdiode 11 auf. Der Brückenzweig der Schalt-Halbbrücke 1 ist an eine Last 13 angeschlossen.

Die Feldeffekttransistoren 5, 7 sind beispielsweise selbstsperrende (normally-off) n-Kanal-Siliziumkarbid-Feldeffekttransistoren, d.h. selbstsperrende n-Kanal-Feldeffekttransistoren, deren Grundmaterial Siliziumkarbid ist und deren Schwellenspannung bei Raumtemperatur zwischen 1 V und 4 V liegt.

Die Schaltanordnung 3 weist einen ersten Gate-Treiber 15 und eine erste Zusatzschaltung 17 zum Ansteuern des ersten Feldeffekttransistors 5 und einen zweiten Gate-Treiber 19 und eine zweite Zusatzschaltung 21 zum Ansteuern des zweiten Feldeffekttransistors 7 auf.

Die Schalt-Halbbrücke 1 ist an einen Gleichspannungszwischenkreis 22 angeschlossen, so dass an der Schalt-Halbbrücke 1 eine Zwischenkreisspannung U_{ZK} des Gleichspannungszwischenkreises 22 anliegt.

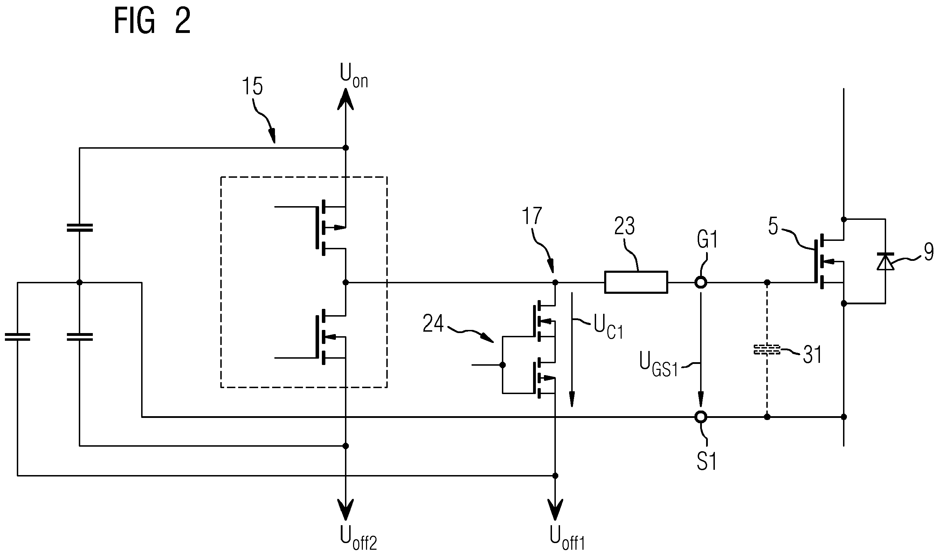

Verschiedene Ausführungsbeispiele der Schaltanordnung 3 und deren Funktionsweise werden im Folgenden anhand der Figuren 2 bis 5 beschrieben.

FIG 2 zeigt ein erstes Ausführungsbeispiel einer Schaltanordnung 3, wobei nur der erste Gate-Treiber 15 und die erste Zusatzschaltung 17 zum Ansteuern des ersten Feldeffekttransistors 5 der Schalt-Halbbrücke 1 dargestellt sind. Der zweite Gate-Treiber 19 und die zweite Zusatzschaltung 21 zum Ansteuern des zweiten Feldeffekttransistors 7 der Schalt-Halbbrücke 1 sind jeweils wie der erste Gate-Treiber 15 und die erste Zusatzschaltung 17 ausgebildet und geschaltet. Zwischen einen Gate-Anschluss G1, G2 des jeweiligen Feldeffekttransistors 5, 7 und den Gate-Treiber 15, 19 sowie die Zusatzschaltung 17, 21 des Feldeffekttransistors 5, 7 ist ein Vorwiderstand 23 geschaltet.

Jede Zusatzschaltung 17, 21 weist einen Zusatz-Gate-Treiber 24 zur Ansteuerung des jeweiligen Feldeffekttransistors 5, 7 auf. Der erste Gate-Treiber 15 und der Zusatz-Gate-Treiber 24 der ersten Zusatzschaltung 17 erzeugen eine erste Steuerspannung U_{C1}, mit der eine Gate-Source-Spannung U_{GS1} zwischen dem Gate-Anschluss G1 und einem Source-Anschluss S1 des ersten Feldeffekttransistors 5 gesteuert wird. Mit dem Zusatz-Gate-Treiber 24 der ersten Zusatzschaltung 17 ist die erste Steuerspannung U_{C1} auf ein erstes Abschaltniveau U_{off1} einstellbar. Mit dem ersten Gate-Treiber 15 ist die erste Steuerspannung U_{C1} auf ein Einschaltniveau Uₒₙ oder ein zweites Abschaltniveau U_{off2} einstellbar, wobei das zweite Abschaltniveau U_{off2} einen größeren Betrag als das erste Abschaltniveau U_{off1} hat. Für als selbstsperrende n-Kanal-Siliziumkarbid-Feldeffekttransistoren ausgebildete Feldeffekttransistoren 5, 7 liegen beispielsweise das erste Abschaltniveau U_{off1} zwischen -3 V und -5 V, das zweite Abschaltniveau U_{off2} zwischen -5 V und -10 V und das Einschaltniveau Uₒₙ zwischen 15 V und 20 V.

Entsprechend erzeugen der zweite Gate-Treiber 19 und die zweite Zusatzschaltung 21 eine zweite Steuerspannung U_{C2}, mit der eine Gate-Source-Spannung U_{GS2} zwischen dem Gate-Anschluss G2 und einem Source-Anschluss S2 des zweiten Feldeffekttransistors 7 gesteuert wird, wobei die zweite Steuerspannung U_{C2} mit der zweiten Zusatzschaltung 21 auf das erste Abschaltniveau U_{off1} und mit dem zweiten Gate-Treiber 19 auf das Einschaltniveau Uₒₙ oder das zweite Abschaltniveau U_{off2} einstellbar ist.

Das Einschaltniveau Uₒₙ ist ein Wert der Gate-Source-Spannungen U_{GS1}, U_{GS2}, bei dem der jeweilige Feldeffekttransistor 5, 7 eingeschaltet, d. h. leitend ist. Die Abschaltniveaus U_{off1}, U_{off2} sind Werte der Gate-Source-Spannungen U_{GS1}, U_{GS2}, bei denen der jeweilige Feldeffekttransistor 5, 7 abgeschaltet, d. h. nichtleitend ist.

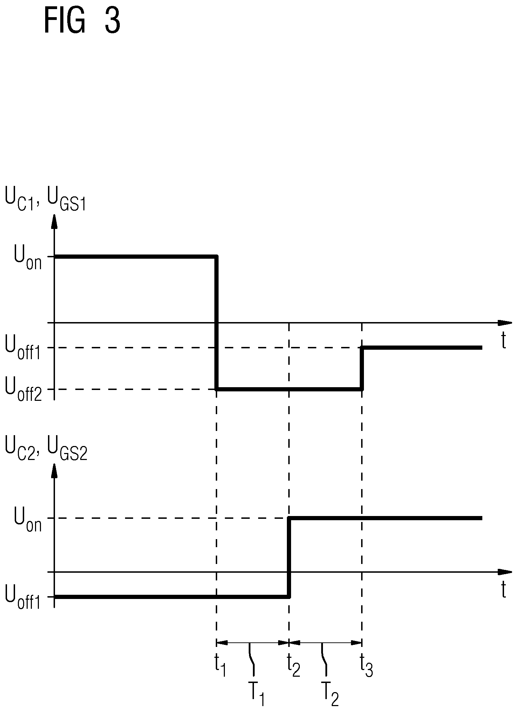

FIG 3 zeigt zeitliche Verläufe von mit der in FIG 2 dargestellten Schaltanordnung 3 erzeugten Steuerspannungen U_{C1}, U_{C2} und der dadurch erzeugten Gate-Source-Spannungen U_{GS1}, U_{GS2} der Feldeffekttransistoren 5, 7. Dargestellt sind die Verläufe der Steuerspannungen U_{C1}, U_{C2} und Gate-Source-Spannungen U_{GS1}, U_{GS2} in Abhängigkeit von einer Zeit t beim erfindungsgemäßen Ändern eines Schaltzustands der Schalt-Halbbrücke 1 von einem ersten Schaltzustand, in dem der erste Feldeffekttransistor 5 eingeschaltet ist und der zweite Feldeffekttransistor 7 abgeschaltet ist, zu einem zweiten Schaltzustand, in dem der erste Feldeffekttransistor 5 abgeschaltet ist und der zweite Feldeffekttransistor 7 eingeschaltet ist. In dem ersten ersten Schaltzustand nimmt die Gate-Source-Spannung U_{GS1} des ersten Feldeffekttransistors 5 das Einschaltniveau Uₒₙ an und die Gate-Source-Spannung U_{GS2} des zweiten Feldeffekttransistors 7 nimmt das erste Abschaltniveau U_{off1} an. In dem zweiten Schaltzustand nimmt die Gate-Source-Spannung U_{GS1} des ersten Feldeffekttransistors 5 das erste Abschaltniveau U_{off1} an und die Gate-Source-Spannung U_{GS2} des zweiten Feldeffekttransistors 7 nimmt das Einschaltniveau Uₒₙ an.

Ausgehend von dem ersten Schaltzustand wird zunächst zu einem ersten Zeitpunkt t₁ die erste Steuerspannung U_{C1} durch den ersten Gate-Treiber 15 von dem Einschaltniveau Uₒₙ zu dem zweiten Abschaltniveau U_{off2} geändert, wobei der Zusatz-Gate-Treiber 24 der ersten Zusatzschaltung 17 abgeschaltet bleibt. Dann wird zu einem zweiten Zeitpunkt t₂ durch den zweiten Gate-Treiber 19 die zweite Steuerspannung U_{C2} von dem ersten Abschaltniveau U_{off1} auf das Einschaltniveau Uₒₙ geändert, wobei der Zusatz-Gate-Treiber 24 der zweiten Zusatzschaltung 21 abgeschaltet wird. Danach wird zu einem dritten Zeitpunkt t₃ durch den Zusatz-Gate-Treiber 24 der ersten Zusatzschaltung 17 die erste Steuerspannung U_{C1} von dem zweiten Abschaltniveau U_{off2} auf das erste Abschaltniveau U_{off1} geändert, wobei der erste Gate-Treiber 15 abgeschaltet wird. Die Gate-Source-Spannung U_{GS1} des ersten Feldeffekttransistors 5 folgt dabei praktisch instantan der ersten Steuerspannung U_{C1}, so dass die Gate-Source-Spannung U_{GS1} des ersten Feldeffekttransistors 5 in FIG 3 mit der ersten Steuerspannung U_{C1} zusammenfällt. Entsprechend folgt die Gate-Source-Spannung U_{GS2} des zweiten Feldeffekttransistors 7 praktisch instantan der zweiten Steuerspannung U_{C2}, so dass die Gate-Source-Spannung U_{GS2} des zweiten Feldeffekttransistors 7 in FIG 3 mit der zweiten Steuerspannung U_{C2} zusammenfällt. Der zweite Zeitpunkt t₂ und der dritte Zeitpunkt t₃ werden dabei durch eine erste Zeitdauer T₁, die den zeitlichen Abstand zwischen t₁ und t₂ definiert, und eine zweite Zeitdauer T₂, die den zeitlichen Abstand zwischen t₂ und t₃ definiert, festgelegt, wobei die beiden Zeitdauern T₁, T₂ vorgegeben und fest eingestellt werden.

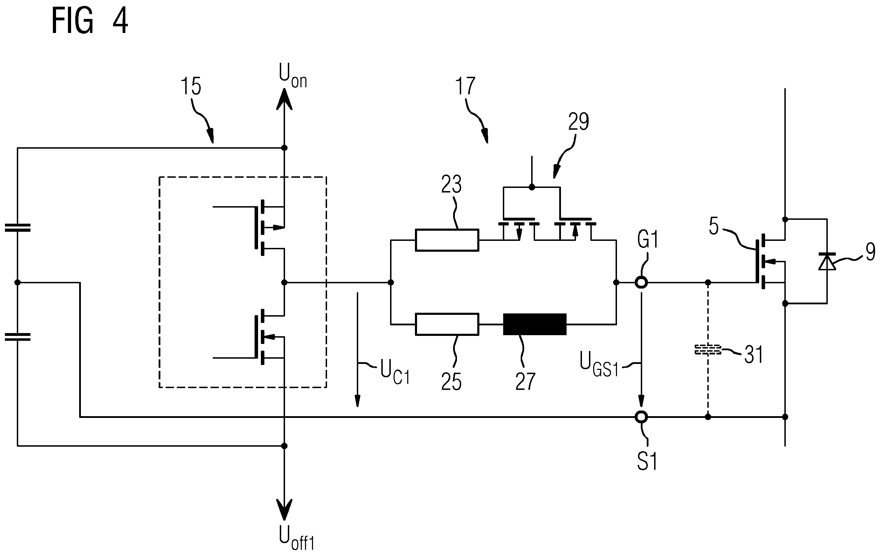

FIG 4 zeigt ein zweites Ausführungsbeispiel einer Schaltanordnung 3, wobei wiederum nur der erste Gate-Treiber 15 und die erste Zusatzschaltung 17 zum Ansteuern des ersten Feldeffekttransistors 5 der Schalt-Halbbrücke 1 dargestellt sind. Der zweite Gate-Treiber 19 und die zweite Zusatzschaltung 21 zum Ansteuern des zweiten Feldeffekttransistors 7 der Schalt-Halbbrücke 1 sind jeweils wie der erste Gate-Treiber 15 und die erste Zusatzschaltung 17 ausgebildet und geschaltet.

Der erste Gate-Treiber 15 erzeugt eine erste Steuerspannung U_{C1} zur Steuerung der Gate-Source-Spannung U_{GS1} zwischen einem Gate-Anschluss G1 und einem Source-Anschluss S1 des ersten Feldeffekttransistors 5. Entsprechend erzeugt der zweite Gate-Treiber 19 eine zweite Steuerspannung U_{C2} zur Steuerung der Gate-Source-Spannung U_{GS2} zwischen einem Gate-Anschluss G2 und einem Source-Anschluss S2 des zweiten Feldeffekttransistors 7.

Jede Zusatzschaltung 17, 21 weist zwei zueinander parallel geschaltete Schaltungszweige auf, wobei ein erster Schaltungszweig einen Dämpfungswiderstand 25 und eine dazu in Reihe geschaltete Induktivität 27 aufweist und der zweite Schaltungszweig einen Vorwiderstand 23 und einen Hilfsschalter 29 aufweist.

Durch Öffnen des Hilfsschalters 29 kann der zweite Schaltungszweig unterbrochen werden, so dass nur der erste Schaltungszweig der Zusatzschaltung 17, 21 wirkt. Der erste Schaltungszweig bildet dann zusammen mit einer Eingangskapazität 31 des jeweiligen Feldeffekttransistors 5, 7, die die Summe der Kapazitäten zwischen Gate und Source und zwischen Gate und Drain des Feldeffekttransistors 5, 7 ist, und einer parasitären Induktivität weiterer Komponenten der Schaltanordnung 1 einen Reihenschwingkreis, der von Änderungen der jeweiligen Steuerspannung U_{C1}, U_{C2} angeregt wird.

Bei geschlossenem Hilfsschalter 29 wird die Wirkung des Reihenschwingkreises unterdrückt und die jeweilige Zusatzschaltung 17, 21 wirkt im Wesentlichen wie ein dem jeweiligen Gate-Anschluss G1, G2 vorgeschalteter ohmscher Widerstand.

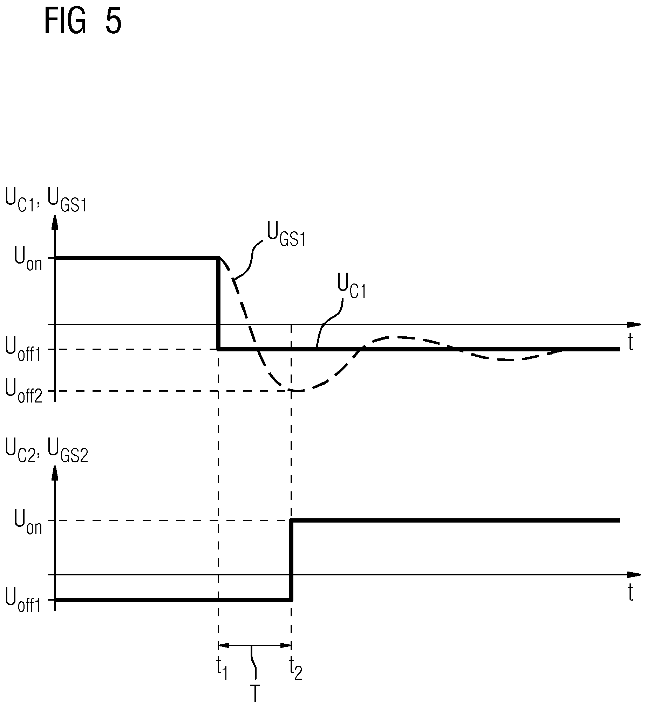

FIG 5 zeigt zeitliche Verläufe von mit der in FIG 4 dargestellten Schaltanordnung 3 erzeugten Steuerspannungen U_{C1}, U_{C2} und der dadurch erzeugten Gate-Source-Spannungen U_{GS1}, U_{GS2} der Feldeffekttransistoren 5, 7. Dargestellt sind die Verläufe der Steuerspannungen U_{C1}, U_{C2} und Gate-Source-Spannungen U_{GS1}, U_{GS2} in Abhängigkeit von einer Zeit t beim erfindungsgemäßen Ändern eines Schaltzustands der Schalt-Halbbrücke 1 von einem ersten Schaltzustand, in dem der erste Feldeffekttransistor 5 eingeschaltet ist und der zweite Feldeffekttransistor 7 abgeschaltet ist, zu einem zweiten Schaltzustand, in dem der erste Feldeffekttransistor 5 abgeschaltet ist und der zweite Feldeffekttransistor 7 eingeschaltet ist. In dem ersten ersten Schaltzustand nimmt die Gate-Source-Spannung U_{GS1} des ersten Feldeffekttransistors 5 das Einschaltniveau Uₒₙ an und die Gate-Source-Spannung U_{GS2} des zweiten Feldeffekttransistors 7 nimmt das erste Abschaltniveau U_{off1} an. In dem zweiten Schaltzustand nimmt die Gate-Source-Spannung U_{GS1} des ersten Feldeffekttransistors 5 das erste Abschaltniveau U_{off1} an und die Gate-Source-Spannung U_{GS2} des zweiten Feldeffekttransistors 7 nimmt das Einschaltniveau Uₒₙ an.

Ausgehend von dem ersten Schaltzustand wird zunächst zu einem ersten Zeitpunkt t₁ die erste Steuerspannung U_{C1} durch den ersten Gate-Treiber 15 von dem Einschaltniveau Uₒₙ zu dem ersten Abschaltniveau U_{off1} geändert, wobei der Hilfsschalter 29 der ersten Zusatzschaltung 17 geöffnet ist, so dass die erste Zusatzschaltung 17, die Eingangskapazität 31 des ersten Feldeffekttransistors 5 und die parasitäre Induktivität weiterer Komponenten der Schaltanordnung 1 wie oben beschrieben einen Reihenschwingkreis bilden. Der Dämpfungswiderstand 25 und die Induktivität 27 der Zusatzschaltung 17 sind derart gewählt, dass die Änderung der ersten Steuerspannung U_{C1} von dem Einschaltniveau Uₒₙ zu dem ersten Abschaltniveau U_{off1} nach einer Zeitdauer T ein Überschwingen der Gate-Source-Spannung U_{GS1} des ersten Feldeffekttransistors 5 bis zu dem zweiten Abschaltniveau U_{off2} bewirkt und die Gate-Source-Spannung U_{GS1} des ersten Feldeffekttransistors 5 sich anschließend mit einer Dämpfung schnell auf das erste Abschaltniveau U_{off1} einschwingt. Zu einem zweiten Zeitpunkt t₂ wird durch den zweiten Gate-Treiber 19 die zweite Steuerspannung U_{C2} von dem ersten Abschaltniveau U_{off1} auf das Einschaltniveau Uₒₙ geändert, wobei der Hilfsschalter 29 der zweiten Zusatzschaltung 21 geschlossen ist, so dass die zweite Zusatzschaltung 21 im Wesentlichen als ein dem Gate-Anschluss G2 des zweiten Feldeffekttransistors 7 vorgeschalteter ohmscher Widerstand wirkt und die Gate-Source-Spannung U_{GS2} des zweiten Feldeffekttransistors 7 praktisch instantan der zweiten Steuerspannung U_{C2} folgt. Der zeitliche Abstand des zweiten Zeitpunkts t₂ von dem ersten Zeitpunkt t₁ wird dabei durch die Zeitdauer T definiert, die vorher bestimmt und fest eingestellt wird.

In beiden oben beschriebenen Ausführungsbeispielen wird also beim Abschalten des ersten Feldeffekttransistors 5 dessen Gate-Source-Spannung U_{GS1} zunächst auf das zweite Abschaltniveau U_{off2} abgesenkt, bevor der zweite Feldeffekttransistor 7 eingeschaltet wird und die Gate-Source-Spannung U_{GS1} des ersten Feldeffekttransistors 5 auf das erste Abschaltniveau U_{off1} eingestellt wird bzw. das erste Abschaltniveau U_{off1} erreicht. Durch diese vorübergehende Absenkung der Gate-Source-Spannung U_{GS1} wird vorteilhaft ein parasitäres Wiedereinschalten (Selfturn-On) des ersten Feldeffekttransistors 5 bei dessen schnellem Abschalten verhindert.

In beiden oben beschriebenen Ausführungsbeispielen wird beim Ändern des Schaltzustands der Schalt-Halbbrücke 1 von dem zweiten Schaltzustand zu dem ersten Schaltzustand analog zu dem beschriebenen Ändern des Schaltzustands von dem ersten Schaltzustand zu dem zweiten Schaltzustand verfahren, wobei lediglich die Gate-Treiber 15, 19 und Zusatzschaltungen 17, 21 ihre Rollen tauschen.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Ändern eines Schaltzustands einer Schalt-Halbbrücke (1), die zwei Feldeffekttransistoren (5, 7) aufweist, von einem ersten Schaltzustand, in dem eine Gate-Source-Spannung (U_{GS1}) eines ersten Feldeffekttransistors (5) ein Einschaltniveau (Uₒₙ) annimmt und eine Gate-Source-Spannung (U_{GS2}) des zweiten Feldeffekttransistors (7) ein erstes Abschaltniveau (U_{off1}) annimmt, zu einem zweiten Schaltzustand, in dem die Gate-Source-Spannung (U_{GS1}) des ersten Feldeffekttransistors (5) das erste Abschaltniveau (U_{off1}) annimmt und die Gate-Source-Spannung (U_{GS2}) des zweiten Feldeffekttransistors (7) das Einschaltniveau (Uₒₙ) annimmt, wobei
- zunächst die Gate-Source-Spannung (U_{GS1}) des ersten Feldeffekttransistors (5) von dem Einschaltniveau (Uₒₙ) auf ein zweites Abschaltniveau (U_{off2}), dessen Betrag größer als der Betrag des ersten Abschaltniveaus (U_{off1}) ist, geändert wird,
- dann die Gate-Source-Spannung (U_{GS2}) des zweiten Feldeffekttransistors (7) von dem ersten Abschaltniveau (U_{off1}) auf das Einschaltniveau (Uₒₙ) geändert wird
- und danach die Gate-Source-Spannung (U_{GS1}) des ersten Feldeffekttransistors (5) von dem zweiten Abschaltniveau (U_{off2}) auf das erste Abschaltniveau (U_{off1}) geändert wird.

2. Verfahren nach Anspruch 1, **dadurch gekennzeichnet, dass** die Gate-Source-Spannung (U_{GS1}) des ersten Feldeffekttransistors (5) von dem Einschaltniveau (Uₒₙ) auf das zweite Abschaltniveau (U_{off2}) geändert wird, indem eine Steuerspannung (U_{C1}) des ersten Feldeffekttransistors (5) von dem Einschaltniveau (Uₒₙ) auf das zweite Abschaltniveau (U_{off2}) geändert wird.

3. Verfahren nach Anspruch 2, **dadurch gekennzeichnet, dass** eine erste Zeitdauer (T₁) vorgegeben wird, und dass die Gate-Source-Spannung (U_{GS2}) des zweiten Feldeffekttransistors (7) von dem ersten Abschaltniveau (U_{off1}) auf das Einschaltniveau (Uₒₙ) zu einem Zeitpunkt (t₂) geändert wird, der in einem durch die erste Zeitdauer (T₁) definierten zeitlichen Abstand auf das Ändern der Steuerspannung (U_{C1}) des ersten Feldeffekttransistors (5) von dem Einschaltniveau (Uₒₙ) auf das zweite Abschaltniveau (U_{off2}) folgt.

4. Verfahren nach Anspruch 2 oder 3, **dadurch gekennzeichnet, dass** die Gate-Source-Spannung (U_{GS1}) des ersten Feldeffekttransistors (5) von dem zweiten Abschaltniveau (U_{off2}) auf das erste Abschaltniveau (U_{off1}) geändert wird, indem die Steuerspannung (U_{C1}) des ersten Feldeffekttransistors (5) von dem zweiten Abschaltniveau (U_{off2}) auf das erste Abschaltniveau (U_{off1}) geändert wird.

5. Verfahren nach einem der Ansprüche 2 bis 4, **dadurch gekennzeichnet, dass** eine zweite Zeitdauer (T₂) vorgegeben wird, und dass die Gate-Source-Spannung (U_{GS1}) des ersten Feldeffekttransistors (5) von dem zweiten Abschaltniveau (U_{off2}) auf das erste Abschaltniveau (U_{off1}) zu einem Zeitpunkt (t₃) geändert wird, der in einem durch die zweite Zeitdauer (T₂) definierten zeitlichen Abstand auf das Ändern der Gate-Source-Spannung (U_{GS2}) des zweiten Feldeffekttransistors (7) von dem ersten Abschaltniveau (U_{off1}) auf das Einschaltniveau (Uₒₙ) folgt.

6. Verfahren nach Anspruch 1, **dadurch gekennzeichnet, dass** einem Gate-Anschluss (G1) des ersten Feldeffekttransistors (5) eine Zusatzschaltung (17) mit einer Induktivität (27) vorgeschaltet wird, die bei einer Änderung einer Steuerspannung (U_{C1}) des ersten Feldeffekttransistors (5) von dem Einschaltniveau (Uₒₙ) auf das erste Abschaltniveau (U_{off1}) eine vorübergehende Änderung der Gate-Source-Spannung (U_{GS1}) des ersten Feldeffekttransistors (5) auf das zweite Abschaltniveau (U_{off2}) bewirkt, und dass zur Änderung der Gate-Source-Spannung (U_{GS1}) des ersten Feldeffekttransistors (5) von dem Einschaltniveau (Uₒₙ) auf das zweite Abschaltniveau (U_{off2}) die Steuerspannung (U_{C1}) des ersten Feldeffekttransistors (5) von dem Einschaltniveau (Uₒₙ) auf das erste Abschaltniveau (U_{off1}) geändert wird.

7. Verfahren nach Anspruch 6, **dadurch gekennzeichnet, dass** eine Zeitdauer (T) vorgegeben wird, und dass die Gate-Source-Spannung (U_{GS2}) des zweiten Feldeffekttransistors (7) von dem ersten Abschaltniveau (U_{off1}) auf das Einschaltniveau (Uₒₙ) zu einem Zeitpunkt (t₂) geändert wird, der in einem durch die Zeitdauer (T) definierten zeitlichen Abstand auf das Ändern der Steuerspannung (U_{C1}) des ersten Feldeffekttransistors (5) von dem Einschaltniveau (Uₒₙ) auf das erste Abschaltniveau (U_{off1}) folgt.

8. Verfahren nach einem der vorhergehenden Ansprüche, **dadurch gekennzeichnet, dass** jeder Feldeffekttransistor (5, 7) als Grundmaterial einen Halbleiter mit breitem Bandabstand aufweist.

9. Verfahren nach Anspruch 8, **dadurch gekennzeichnet, dass** das Grundmaterial Siliziumkarbid ist.

10. Schaltanordnung (3) zum Ändern eines Schaltzustands einer Schalt-Halbbrücke (1), die zwei Feldeffekttransistoren (5, 7) aufweist, von einem ersten Schaltzustand, in dem eine Gate-Source-Spannung (U_{GS1}) eines ersten Feldeffekttransistors (5) ein Einschaltniveau (Uₒₙ) annimmt und eine Gate-Source-Spannung (U_{GS2}) des zweiten Feldeffekttransistors (7) ein erstes Abschaltniveau (U_{off1}) annimmt, zu einem Schaltzustand, in dem die Gate-Source-Spannung (U_{GS1}) des ersten Feldeffekttransistors (5) das erste Abschaltniveau (U_{off1}) annimmt und die Gate-Source-Spannung (U_{GS2}) des zweiten Feldeffekttransistors (7) das Einschaltniveau (Uₒₙ) annimmt, die Schaltanordnung (3) aufweisend
- für jeden Feldeffekttransistor (5, 7) einen Gate-Treiber (15, 19) zum Ansteuern des Feldeffekttransistors (5, 7) mit einer Steuerspannung (U_{C1}, U_{C2}),
- und für jeden Feldeffekttransistor (5, 7) eine zwischen den Gate-Treiber (15, 19) und einen Gate-Anschluss (G1, G2) des Feldeffekttransistors (5, 7) schaltbare Zusatzschaltung (17, 21),
- wobei durch den Gate-Treiber (15, 19) und die Zusatzschaltung (17, 21) eine Gate-Source-Spannung (U_{GS1}, U_{GS2}) des Feldeffekttransistors (5, 7) auf das Einschaltniveau (Uₒₙ), das erste Abschaltniveau (U_{off1}) und ein zweites Abschaltniveau (U_{off2}), dessen Betrag größer als der Betrag des ersten Abschaltniveaus (U_{off1}) ist, einstellbar ist.

11. Schaltanordnung (3) nach Anspruch 10, **dadurch gekennzeichnet, dass** jede Zusatzschaltung (17, 21) einen Zusatz-Gate-Treiber (24) zur Einstellung der Steuerspannung (U_{C1}, U_{C2}) auf das erste Abschaltniveau (U_{off1}) aufweist, und mit dem Gate-Treiber (15, 19) die Steuerspannung (U_{C1}, U_{C2}) auf das Einschaltniveau (Uₒₙ) und das zweite Abschaltniveau (U_{off2}) einstellbar ist.

12. Schaltanordnung (3) nach Anspruch 10, **dadurch gekennzeichnet, dass** jede Zusatzschaltung (17, 21) eine Induktivität (27) aufweist, die bei einer Änderung der Steuerspannung (U_{C1}, U_{C2}) von dem Einschaltniveau (Uₒₙ) auf das erste Abschaltniveau (U_{off1}) eine vorübergehende Änderung der Gate-Source-Spannung (U_{GS1}, U_{GS2}) des jeweiligen Feldeffekttransistors (5, 7) auf das zweite Abschaltniveau (U_{off2}) bewirkt.

13. Schaltanordnung (3) nach einem der Ansprüche 10 bis 12, **dadurch gekennzeichnet, dass** jeder Feldeffekttransistor (5, 7) als Grundmaterial einen Halbleiter mit breitem Bandabstand aufweist.

14. Schaltanordnung (3) nach Anspruch 13, **dadurch gekennzeichnet, dass** das Grundmaterial Siliziumkarbid ist.

15. Stromrichter (100) mit wenigstens einer Schalt-Halbbrücke (1), die zwei Feldeffekttransistoren (5, 7) aufweist, und einer gemäß einem der Ansprüche 10 bis 14 ausgebildeten Schaltanordnung (3) zum Ändern eines Schaltzustands der Schalt-Halbbrücke (1).
